# EUROPÄISCHE PATENTSCHRIFT

(11) **EP 2 528 091 B1**
(45) Veröffentlichungstag und Bekanntmachung des Hinweises auf die Patenterteilung: **01.03.2017**
(21) Anmeldenummer: 12161531.4
(22) Anmeldetag: 27.03.2012
(51) Int. Cl.: H01L 23/367, H01L 23/40, H01L 23/36, H01L 21/48, H01L 25/07, H05K 7/20

(54) **Leistungselektronisches System mit Subsystemen und einer Kühleinrichtung**
High performance electronic system with subsystem and a cooling device
Système électronique de puissance avec sous-systèmes et dispositif de refroidissement

(30) Priorität: 24.05.2011 DE 102011076325
(43) Veröffentlichungstag der Anmeldung: 28.11.2012
(73) Patentinhaber: SEMIKRON Elektronik GmbH & Co. KG, 90431 Nürnberg (DE)
(72) Erfinder: Popp, Rainer, 91580 Petersaurach (DE); Popescu, Alexander, 90431 Nürnberg (DE); Weiß, Stefan, 91315 Höchstadt (DE)

(56) Entgegenhaltungen:
- EP-A2- 2 151 913
- JP-A- 2004 134 542
- US-A- 6 021 045
- US-A1- 2003 169 983
- US-A1- 2008 068 805
- US-B1- 6 549 407

## Beschreibung

Die Erfindung beschreibt ein integriertes leistungselektronisches System, vorzugsweise zur Ausbildung einer damit realisierten Schaltungsanordnung in Form eines Stromrichters, beispielhaft eines Drei-Phasen-Wechselrichters. Derartige Systeme finden bevorzugt Anwendung in elektrischen Antrieben verschiedener Arten von Fahrzeugen, speziell auch bei Nutzfahrzeugen.

Es ist grundsätzlich bekannt derartige leistungselektronische System aus einzelnen Leistungshalbleitermodulen beispielhaft gemäß der DE 10 2009 037 257 A1 mit externer Verschienung, also der Verbindung der externen Anschlusselemente der Leistungshalbleitermodule miteinander aufzubauen. Derartige Systeme weisen den Vorteil auf durch Skalierung beliebig an die notwendige Leistung angepasst werden zu können. Zur Kühlung der Leistungshalbleitermodule werden diese in fachüblicher Weise auf einer Kühleinrichtung montiert.

Es ist ebenso bekannt derartige leistungselektronische Systeme als integrierte Systeme, beispielhaft gemäß der DE 101 27 947A1 auszugestalten. Bei einem derartigen als Drei-Phasen-Wechselrichter aufgebauten Systemen sind den drei Phasen jeweils eigene Schalteinrichtungen zugeordnet, die mit einer gemeinsamen internen Gleichspannungsverbindung miteinander und mit externen Gleichspannungs-Lastanschlusselementen verbunden sind. Es ist bekannt diese Gleichspannungsverbindung unmittelbar mit einer gemeinsamen Kondensatoreinrichtung für alle Schalteinrichtungen zu verbinden. Derartige Systeme werden zu ihrer Kühlung auf einer Kühleinrichtung montiert.

Aus der EP 2 151 913 A2 und vereinfacht auch aus der JP 2004 134542 A ist ein leistungselektronisches System bekannt, das eine Mehrzahl von Subsystemen aufweist, die ihrerseits Kühlelemente aufweisen die in eine Kühleinrichtung des Systems hineinragen. Diese Kühlelemente dienen der Kühlung der Subsystem, wobei hier die Kühleinrichtung eine Flüssigkeitskühleinrichtung ausgebildet ist.

Aus der US 2003/0169983 A1 ist eine Kühleinrichtung bekannt, die modular aufgebaut ist indem ein Hauptkühlkörper Ausnehmungen aufweist, in den Teilkühlkörper angeordnet sind.

Der Erfindung liegt die Aufgabe zugrunde ein leistungselektronisches System vorzustellen, das eine kompakte Einheit bildet, modular aufbaubar ist und gleichzeitig einer verbesserte Kühlung aufweist.

Die Aufgabe wird erfindungsgemäß gelöst, durch ein leistungselektronisches System mit den Merkmalen des Anspruchs 1. Bevorzugte Ausführungsformen sind in den jeweiligen abhängigen Ansprüchen beschrieben.

Das vorgestellte leistungselektronische System weist eine Kühleinrichtung, mindestens ein Subsystem, sowie ein dieses mindestens eine Subsystem zur Kühleinrichtung hin überdeckendes Gehäuse auf. Bei einer Mehrzahl von Subsystemen sind diese vorzugsweise alle in einer Reihe nebeneinander angeordnet.

Das mindestens eine Subsystem weist eine Schalteinrichtung mit einem Kühlbauteil mit mindestens einem zweiten Grundkörper, einen ersten Isolierstoffkörper und mindestens ein externes Lastanschlusselement auf. Die Schalteinrichtung wird vorzugsweise aus mindestens einem elektrisch isolierenden Substrat mit auf dessen erster Hauptfläche angeordneten und schaltungsgerecht verbundenen Leistungshalbleiterbauelementen, die die leistungselektronischen Schaltung ausbilden, gebildet. Die Schalteinrichtung weist weiterhin interne Anschlusselemente verschiedener Polarität auf, die mit zugeordneten externen Last- und / oder Hilfsanschlusselementen ein- oder mehrstückig verbunden sind.

Die Kühleinrichtung ist vorzugsweise entweder für gasförmige oder für flüssige Kühlmedien ausgebildet. In erstem Falls weist sie eine Rippenkühleinrichtung mit einem ersten plattenförmigen Grundkörper und von diesem wegstehenden ersten Kühlrippen auf, während sie im zweiten Fall ebenfalls einen ersten plattenförmigen Grundkörper aufweist an den sich allerdings mindestens ein Hohlraum für das Kühlmedium anschließt.

Weiterhin weist die Kühleinrichtung mindestens eine Ausnehmung in dem ersten plattenförmigen Grundkörper zur Anordnung eines zugeordneten Kühlbauteiles einer Schalteinrichtung eines Subsystems auf. Das jeweilige Kühlbauteil des zugeorndeten Subsystems wird hierbei durch die Ausnehmung vollständig aufgenommen.

Zur Anordnung des Kühlbauteils eines Subsystems kann es zudem vorteilhaft sein, wenn er Grundkörper eine vorzugsweise umlaufende Anschlagkante aufweist, auf der eine zugeordnete Anschlagfläche des Kühlbauteils zu liegen kommt. Weiterhin kann hier zwischen der Anschlagkante und der Anschlagfläche in fachüblicher Weise eine Dichteinrichtung vorgesehen sein. Dies ist insbesondere bei Ausgestaltung der Kühlreinrichtung als Flüssigkeitskühleinrichtung vorteilhaft. Die jeweilige Dichteinrichtung kann ebenso in einem Randbereiche zwischen dem ersten Grundkörper der Kühleinrichtung und dem zweiten Grundkörper des Kühlbauteils vorgesehen sein.

Bei einer Kühleinrichtung für gasförmige Kühlmedien kann dieser Dichteinrichtung ebenfalls vorgesehen sein. Allerdings kann bevorzugt auf diese verzichtet werden, wenn das Subsystem selbst dicht ausgebildet ist. Hierzu kann ein zweiter Isolierstoffkörper die Schalteinrichtung umschließen und somit zum Kühlbauteil hin hermetisch dicht abschließen. Hierbei ist es bevorzugt, wenn die Last- und Hilfsanschlusselemente der Schalteinrichtung durch Aussparungen des zweiten Isolierstoffkörpers hindurchreichen und diese Aussparungen staub- und feuchtigkeitsdicht zu den Last- und Hilfsanschlusselementen hin verschlossen sind.

Bei erhöhten Anforderungen an die Dichtigkeit gegen Staub oder sogar Flüssigkeit kann eine derartige hermetische Abdichtung auch in anderen Ausgestaltungen der Kühlreinrichtung vorgesehen sein.

Die erfinderische Lösung wird an Hand der Ausführungsbeispiele gemäß den Fig. 1 bis 5 weiter erläutert.
Fig. 1 zeigt in dreidimensionaler Darstellung ein erfindungsgemäßes leistungselektronisches System mit seinem Gehäuse.
Fig. 2 zeigt eine erste Ausgestaltung einer Kühleinrichtung eines erfindungsgemäßen leistungselektronischen Systems.
Fig. 3 zeigt eine die Erfindung weiter erläuternde Ausgestaltung einer Kühleinrichtung eines leistungselektronischen Systems.
Fig. 4 zeigt eine hermetisch abgedichtet Schalteinrichtung eines erfindungsgemäßen leistungselektronischen Systems.
Fig. 5 zeigt in dreidimensionaler Darstellung ein erfindungsgemäßes leistungselektronisches Systems in Explosionsdarstellung ohne Gehäuse.

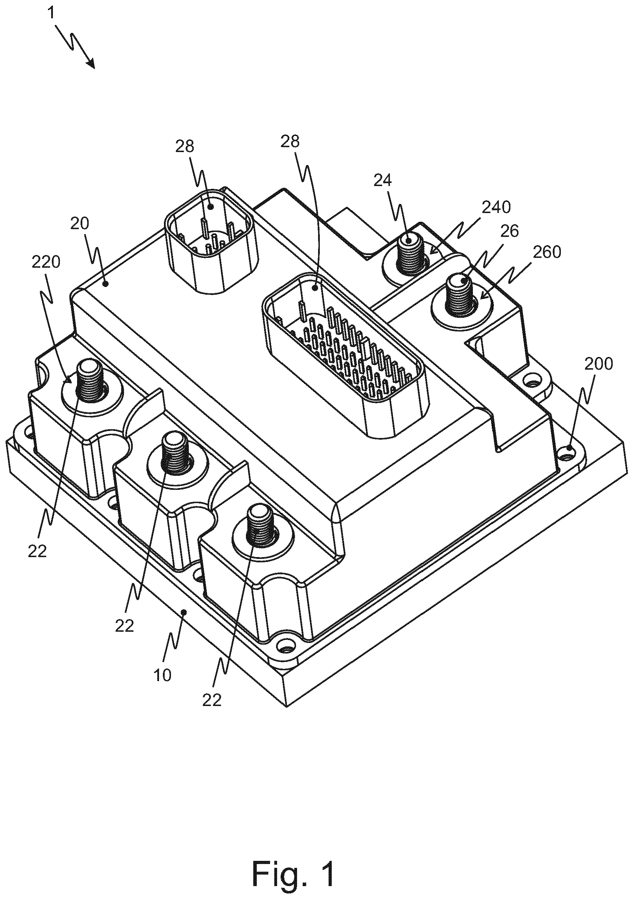

Fig. 1 zeigt in dreidimensionaler Darstellung ein erstes erfindungsgemäßes leistungselektronisches System 1 in Ausgestaltung eines Drei-Phasen-Wechselrichters. Schematisch dargestellt ist eine Kühleinrichtung 10, beispielhaft ausgebildet als eine Wasserkühleinrichtung. Interne Komponenten des Systems werden durch ein Gehäuse 20 zu dieser Kühleinrichtung 10 hin überdeckt. Das Gehäuse 10 selbst wird an entsprechenden Ausnehmungen 220, 240, 260 durch die externen Anschlusselemente 22, 24, 26 durchdrungen.

An einer ersten Seite des Gehäuses 10 sind die beiden externen Gleichspannungs-Lastanschlusselemente 24, 26 angeordnet, die als Schraubverbindungen ausgebildet sind. Auf der gegenüberliegenden zweiten Seite des Gehäuses 10 sind die externen Wechselspannungs-Lastanschlusselemente 22 in grundsätzlich gleicher technischer Ausprägung dargestellt.

An der Oberseite sind zwei Gruppen externer Hilfsanschlusselemente 28 vorgesehen, die insbesondere zum Anschluss von Steuer- und Sensorsignalen dienen.

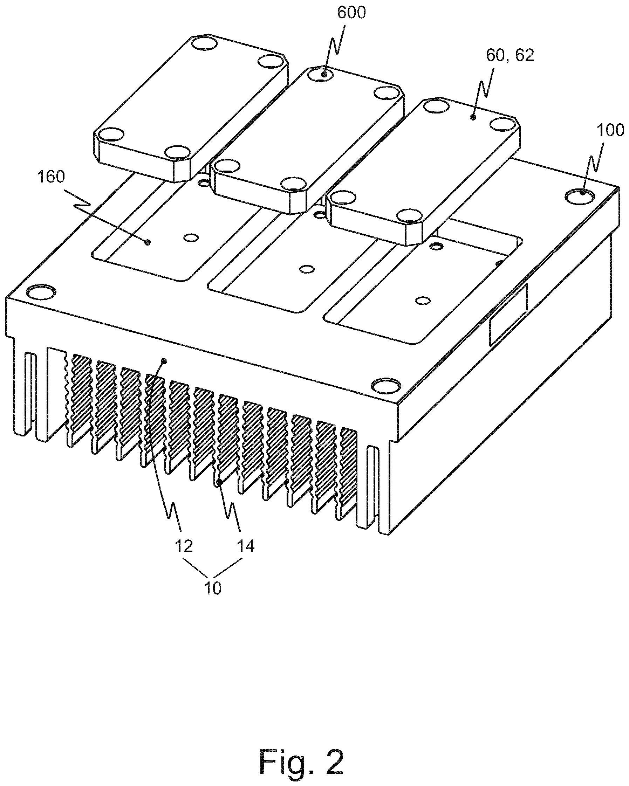

Fig. 2 zeigt eine erste Ausgestaltung einer Kühleinrichtung 10 eines ersten erfindungsgemäßen leistungselektronischen Systems. Diese erste Ausgestaltung der Kühleinrichtung 10 für gasförmige Kühlmedien weist einen ersten plattenförmigen Grundkörper 12 und von diesem wegstehend erste Kühlrippen 14 auf. Die weiteren Ausführungen gelten nötigenfalls in angepasster Weise auch für andere Ausgestaltungen der Kühleinrichtungen, insbesondere bei deren Ausgestaltung für flüssige Kühlmedien.

Auf der den Kühlrippen 14 gegenüber liegenden Seite der Kühleinrichtung 10 sind drei Ausnehmung 160 vorgesehen, die bis zur halben Dicke des plattenförmigen Grundkörpers 12 in diesen hineinreichen.

In Art einer Explosionszeichnung dargestellt sind drei Kühlbauteile 60 von drei Subsystemen des ersten erfindungsgemäßen leistungselektronischen Systems. Diese Kühlbauteile 60 bestehen jeweils nur aus einem zweiten Grundkörper 62, der formschlüssig und vollständig in den Ausnehmungen 160 des ersten Grundkörpers 12 der Kühleinrichtung 10 zu liegen kommt. Hierdurch ergibt sich eine plane Oberfläche für die weiteren Komponenten des leistungselektronischen Systems. Diese Ausgestaltung ist bevorzugt, allerdings nicht notwendig. Es kann auch vorteilhaft sein, wenn der jeweilige zweite Grundkörper 62 nur teilweise innerhalb der zugeordneten Ausnehmung 160 des ersten Grundkörpers 12 zu liegen kommt. Hierbei kann dieser zweite Grundkörper 62 somit auch partiell eine größere Ausdehnung parallel zur Oberfläche des ersten Grundkörpers 12 annehmen als durch die Ausmaße der Ausnehmung 160 vorgegeben. In diesem Fall ergibt sich somit ein Überstand über horizontal über die jeweilige Ausnehmung 160 hinaus.

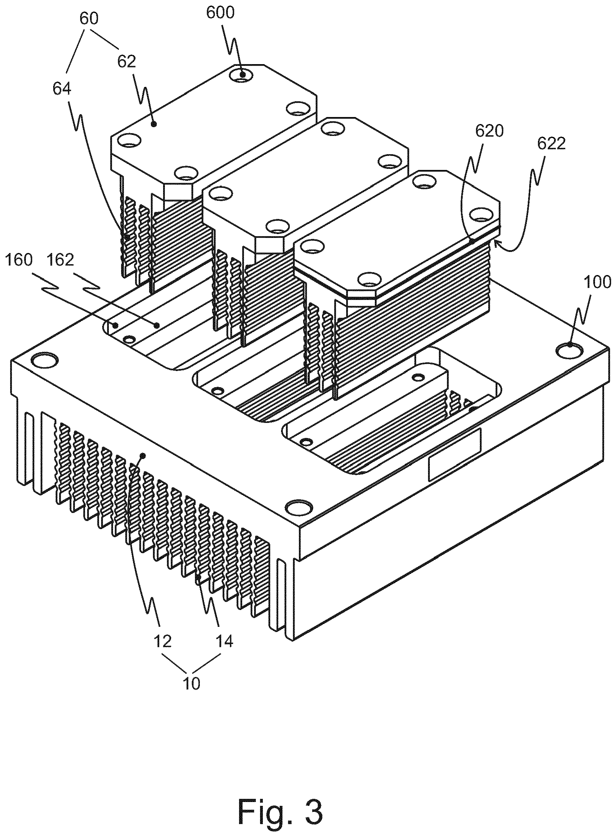

Fig. 3 zeigt eine die Erfindung weiter erläuternde Ausgestaltung einer Kühleinrichtung 10, ebenfalls für gasförmige Kühlmedien eines zweiten leistungselektronischen Systems. Grundsätzlich gilt analog zu Fig. 2 das Folgende in angepasster Form auch für Kühleinrichtungen mit flüssigem Kühlmedium.

Der erste Grundkörper 12 weist hier eine Mehrzahl von Ausnehmungen 160 auf, die den gesamten ersten Grundkörper 12 durchdringen. Weiterhin sind im Bereich der Ausnehmung 12 hier keine ersten Kühlrippen 14 der Kühleinrichtung 10 vorgesehen. Zusätzlich ist hier an zwei gegenüberliegenden Seiten, hier den Längsseiten, der jeweiligen Ausnehmung 160 eine Anschlagkante 162 vorgesehen.

Weiterhin sind in Art einer Explosionszeichnung dargestellt drei Kühlbauteile 60 von drei Subsystemen des zweiten leistungselektronischen Systems. Diese Kühlbauteile 60 weisen einen zweiten plattenförmigen Grundkörper 62 auf, der zugeordnet den Anschlagkanten 162 der Ausnehmungen 160 des ersten Grundkörpers 12 Anschlagflächen 622 aufweist. Diese Anschlagflächen 622 des zweiten Grundkörpers 62 kommen auf den Anschlagkanten 162 des ersten Grundkörpers 12 zu liegen. Es kann hier vorteilhafterweise eine Dichteinrichtung 620 vorgesehen sein, die im Randbereich der Ausnehmung 160 zwischen dem ersten 12 und dem zweiten Grundkörper 62 angeordnet ist. Bei einer umlaufenden Anschlagkante 162 in der Ausnehmung 160 des ersten Grundkörpers 12 kann diese Dichteinrichtung auch zwischen dieser Anschlagkante 162 und der Anschlagfläche 622 des zweiten Grundkörpers 62 angeordnet sein.

Bei der dargestellten Ausgestaltung weisen die Kühlbauteile 60 von dem zweiten Grundkörper 62 wegstehende zweite Kühlrippen 64 auf. Diese sind hier, ohne Beschränkung der Allgemeinheit, derart ausgebildet, dass sie bei Anordnung des jeweiligen Kühlbauteils 60 in der vorgesehenen Ausnehmung 160 mit den ersten Kühlrippen 14 der Kühleinrichtung 10 fluchten. Insbesondere sind hier die zweiten Kühlrippen 64 in Form, Abstand und lateraler Ausdehnung sogar identisch zu den ersten Kühlrippen 14. Somit ergibt sich quasi eine homogene Ausgestaltung der Kühlrippenstruktur des zweiten leistungselektronischen Systems durch die Kombination der Kühlreinrichtung 10 mit den Kühlbauteilen 60.

Hier, wie auch bei dem ersten leistungselektronischen System gemäß Fig. 2, sind bevorzugt geeignete Verbindungseinrichtungen 600 vorgesehen zwischen den Kühlbauteilen 60 der Subsysteme und der Kühleinrichtung 10 zur allgemeinen Fixierung der Komponenten wie auch zur ggf. notwendigen Druckbeaufschlagung von vorgesehenen Dichteinrichtungen 622. Weitere Verbindungseinrichtungen 100 dienen der Verbindung des Gehäuses mit dem Kühlbauteil 10.

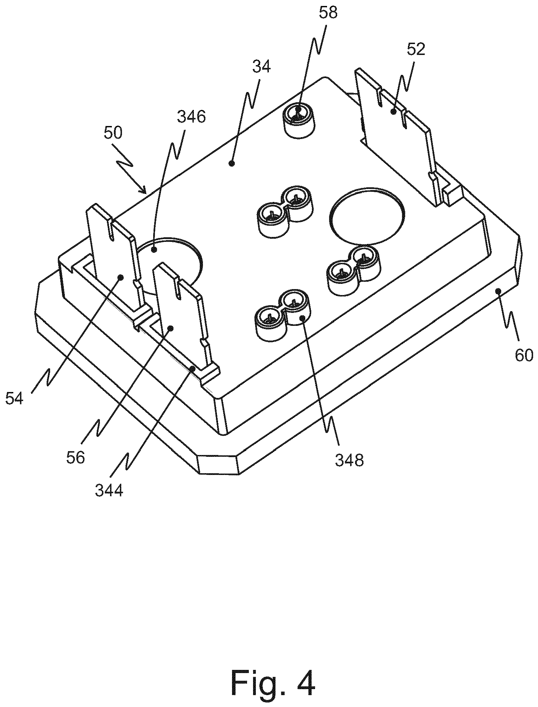

Fig. 4 zeigt eine hermetisch abgedichtet Schalteinrichtung 50 eines erfindungsgemäßen leistungselektronischen Systems. Es kann vorteilhaft sein, anstelle von Dichteinrichtungen, wie unter Fig. 3 beschrieben, oder zusätzlich zu diesen die jeweiligen Schalteinrichtungen 50 der Subsysteme hermetisch gegen Umwelteinflüsse abzudichten.

Hierbei kann ein zweiter Isolierstoffkörper 34 vorgesehen sein, der mindestens ein Substrat mit einer hierauf angeordneten leistungselektronischen Schaltung der Schalteinrichtung 50 umschließt, überdeckt und zum Kühlbauteil 60 hin einschließt. Herfür kann dieser zweite Isolierstoffkörper 34 becherartig ausgebildet sein und eine Mehrzahl von staub- und feuchtigkeitsdicht verschließbaren Durchführungen 344, 348 aufweisen. Durch diese Ausführungen 344, 348 ragen die Last- 52, 54, 56 und Hilfsanschlusselemente 58 hindurch. Weiterhin kann mindestens eine Membran 346 in diesem zweiten Isolierstoffkörper 34 vorgesehen sein, die druckausgleichend wirkt. Je nach Anforderungsklasse an die Dichtheit kann diese Membrane 346 alternativ oder zusätzlich Feuchtigkeit vorzugsweise aus dem Inneren nach außen transportierend ausgeführt sein.

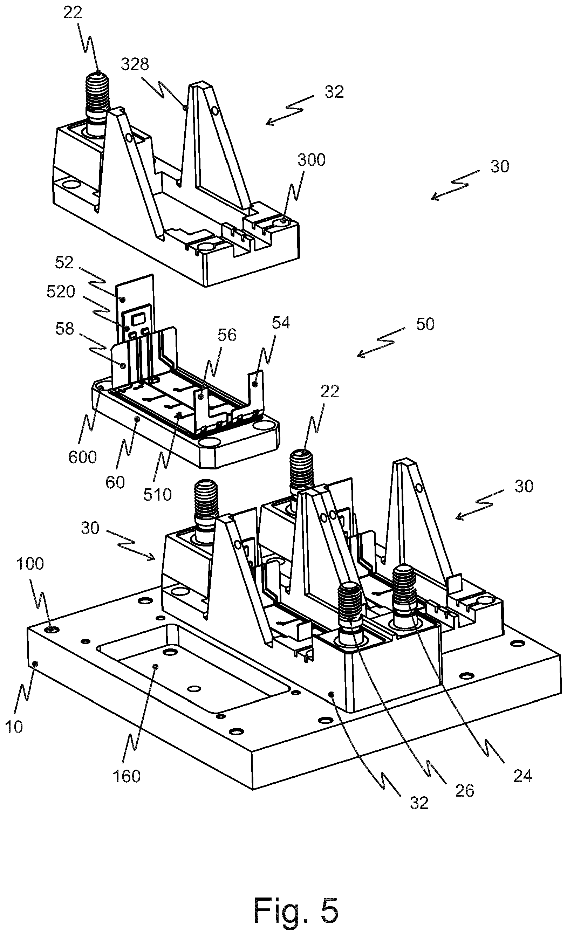

Fig. 5 zeigt in dreidimensionaler Darstellung ein erfindungsgemäßes leistungselektronisches Systems 1 in Explosionsdarstellung ohne Gehäuse.

Dargestellt ist wiederum eine Kühleinrichtung 10, hier mit einer Mehrzahl von Ausnehmungen160, jeweils zur Anordnung von einzelnen Kühlbauteilen 60 von jeweils zugehörigen Subsystemen 30, wobei jedes dieser Subsysteme 30 eine leistungselektronische Schaltung in Halbbrückentopologie beinhaltet wodurch das leistungselektronische System 1 eine Drei-Phasen-Brückenschaltung ausbildet.

Die Subsysteme 30 weisen jeweils ein Kühlbauteil 60 mit einem hierauf stoffschlüssig und thermisch leitend verbundenen Substrat auf. Auf der dem Kühlbauteil gegenüberliegenden Seite des Substrats ist die leistungselektronische Schaltung 510 vorgesehen, die mit dem Substrat und dem Kühlbauteil 60 die Schalteinrichtung 50 des Subsystems 30 bildet. Von der leistungselektronischen Schaltung 510 gehen interne Anschlusselemente 52, 54, 56, 58 aus. Hier dargestellt sind die jeweils zwei Gleichspannungs-Lastanschlusselemente 54, 56, ein Wechselspannungslastanschlusselement 52 und eine Mehrzahl von Steueranschlusselementen 58. Diese Steueranschlusselemente 58 sind hier als eine Anschlusslasche ausgebildet, wobei als Alternative hierzu, beispielhaft Federkontaktelemente oder Kontaktstifte, ebenfalls geeignet sind.

Die internen Lastanschlusselemente 52, 54, 56 sind jeweils als flächige Laschen ausgebildet. Die externen Lastanschlusselemente 22, 24 ,26 ragen wie in Fig. 1 dargestellt durch das hier nicht dargestellte Gehäuse hindurch.

Angeordnet sind die externen Lastanschlusselemente 22, 24, 26 auf einem ersten Isolierstoffkörper 32, der ebenfalls Teil des Subsystems 30 ist. Dieser erste Isolierstoffkörper 32 kann einstückig mit dem zweiten Isolierstoffkörper 34 gemäß Fig. 4 ausgeführt sein. Dieser erste Isolierstoffkörper 32 umschließt weiterhin rahmenartig die Schalteinrichtung 50 und weist Befestigungseinrichtungen 300 auf, um das Subsystem 30 und damit auch die Schalteinrichtung 50 zur Kühleinrichtung 10 zu fixieren. In der dargestellten Ausgestaltung weist die Kühleinrichtung 10 jeweils eine Ausnahme 160, in Form einer Vertiefung, auf in der das zugeordnete Kühlbauteil 160 der jeweiligen Schalteinrichtung 50 vollständig zu liegen kommt. Somit kann der erste Isolierstoffkörper 32 flächig auf dem Kühlbauteil 10 aufliegen und somit die Schalteinrichtung 50 mechanisch robust zur Kühleinrichtung 10 fixieren. Somit wird die gesamte Schalteinrichtung 50 hierbei nur teilweise vom Isolierstoffkörper 32 in demjenigen oberen Bereich, der aus der Kühleinrichtung 10 herausragt, umfasst.

Weiterhin weist jeder erste Isolierstoffkörper 32 eine Halteeinrichtung 328 zur Fixierung einer zugeordneten nicht dargestellten Schaltplatine, die die Steuerschaltung für das Subsystem 30 beinhaltet, auf. Diese Schaltplatine ist bevorzugt in unmittelbarer Nähe zum internen Wechselspannungs-Lastanschlusselement 22 vorgesehen.

Jeder der ersten Isolierstoffkörper 32 weist eine rechteckige Grundform auf, die auch die Grundform jedes Subsystems 30 bildet. Die internen 52, 54, 56 und externen Lastanschlusselemente 22, 24, 26 sind hierbei derart den Schmalseiten dieser Grundform zugeordnet, dass die ersten Isolierstoffkörper 32 und damit die Subsysteme 30 über ihre Längsseiten aneinander anreihbar sind um das leistungselektronische System 1 besonders kompakt auszugestalten.

Ebenso ist bevorzugt, allerdings nicht dargestellt, eine Kondensatoreinrichtung je Subsystem 30 an dem zugeordneten Isolierstoffkörper 32 befestigt vorzusehen. Diese Kondensatoreinrichtung ist fachüblich polaritätsrichtig mit den zugeordneten Lastanschlusselementen 54, 56 der zugeordneten Schalteinrichtung 50 verbunden. Zur internen Verbindung der externen Gleichspannungs-Lastanschlusselemente mit den internen Gleichspannungs-Lastanschlusselementen 54, 56 sind nicht dargestellte Verbindungseinrichtungen vorgesehen.

## Patentansprüche

1. Leistungselektronisches System (1) mit einer Kühleinrichtung (10) mit einem ersten Grundkörper (12), mindestens einem Subsystem (30) und einem Gehäuse (20), wobei die Kühleinrichtung (10) in ihrem ersten Grundkörper (12) mindestens eine Ausnehmung (160) aufweist,
das mindestens eine Subsystem (30) eine Schalteinrichtung (50) mit einer leistungselektronischen Schaltung mit Last- (52, 54, 56) und Hilfsanschlusselementen (58) verschiedener Polarität und mit einem, in eine zugeordnet Ausnehmung (160) der Kühleinrichtung (10), die eine Vertiefung des ersten Grundkörpers (12) ausbildet, hineinreichenden Kühlbauteil (60), das jeweils nur aus einem zweiten Grundkörper (62) bestehend, der formschlüssig und vollständig in der Ausnehmung (160) des ersten Grundkörpers (12) der Kühleinrichtung (10) aufgenommen ist und somit dort zu liegen kommt, aufweist,
und wobei
das Gehäuse (20) das mindestens eine Subsystem (30) zur Kühleinrichtung (10) hin überdeckt.

2. Leistungselektronisches System nach Anspruch 1, wobei
die Kühleinrichtung (10) für gasförmige Kühlmedien vorgesehen ist und hierzu als Rippenkühleinrichtung mit einem ersten plattenförmigen Grundkörper (12) und von diesem wegstehenden ersten Kühlrippen (14) ausgebildet ist.

3. Leistungselektronisches System nach Anspruch 1, wobei
die Kühleinrichtung (10) für flüssige Kühlmedien vorgesehen ist und hierbei einen ersten plattenförmigen Grundkörper (12) aufweist und an diesen anschließend mindestens ein Hohlraum für das Kühlmedium vorgesehen ist.

4. Leistungselektronisches System nach Anspruch 1, wobei
die mindestens eine Ausnehmung (160) eine umlaufende Anschlagkante (162) aufweist auf der eine Anschlagfläche (622) der jeweils zugeordneten Kühleinrichtung (60) des Subsystems (30) aufliegt.

5. Leistungselektronisches System nach Anspruch 1 oder 4, wobei
im Randbereich zwischen dem ersten (12) und dem zweiten Grundkörper (62) oder zwischen der Anschlagkante (162) des ersten Grundköpers (12) und der Anschlagfläche (622) des zweiten Grundkörpers (62) eine Dichteinrichtung (622) vorgesehen ist.

6. Leistungselektronisches System nach Anspruch 1, wobei
ein erster Isolierstoffkörper (32) mindestens ein Substrat mit einer leistungselektronischen Schaltung (510) einer Schalteinrichtung (50) umschließt, überdeckt und zum Kühlbauteil (60) hin hermetisch dicht einschließt.

7. Leistungselektronisches System nach Anspruch 11, wobei
die Last- (52, 54, 56) und Hilfsanschlusselementen (58) durch Durchführungen (344, 348) des zweiten Isolierstoffkörpers (34) hindurchreichen und diese Durchführungen (344, 348) staub- und feuchtigkeitsdicht zu den Last- (52, 54, 56) und Hilfsanschlusselementen (58) hin verschlossen sind.

## Claims

1. Power electronic system (1) having a cooling device (10) with a first base body (12), at least one subsystem (30) and a housing (20), the cooling device (10) having at least one recess (160) in its first base body (12),
the at least one subsystem (30) having a switching device (50) with a power electronic circuit having load connection elements (52, 54, 56) and auxiliary connection elements (58) of different polarity and with a cooling component (60) which extends into an associated recess (160) in the cooling device (10), which recess (160) forms a depression in the first base body (12), and, respectively consisting only of a second base body (62) which is accommodated completely in a formfitting manner in the recess (160) of the first base body (12) of the cooling device (10) and therefore comes to rest there
and
the housing (20) covering the at least one subsystem (30) towards the cooling device (10).

2. Power electronic system according to Claim 1,
the cooling device (10) being intended for gaseous cooling media and, for this purpose, being in the form of a ribbed cooling device having a first plate-shaped base body (12) and first cooling ribs (14) which project from the latter.

3. Power electronic system according to Claim 1,
the cooling device (10) being intended for liquid cooling media and, in this case, having a first plate-shaped base body (12), and at least one cavity for the cooling medium being provided in a manner adjoining said base body.

4. Power electronic system according to Claim 1,
the at least one recess (160) having a circumferential stop edge (162) on which a stop surface (622) of the respective associated cooling device (60) of the subsystem (30) rests.

5. Power electronic system according to Claim 1 or 4, a sealing device (622) being provided in the edge region between the first base body (12) and the second base body (62) or between the stop edge (162) of the first base body (12) and the stop surface (622) of the second base body (62).

6. Power electronic system according to Claim 1,
a first insulating material body (32) surrounding at least one substrate with a power electronic circuit (510) of a switching device (50), covering said substrate and enclosing the latter in a hermetically sealed manner towards the cooling component (60).

7. Power electronic system according to Claim 11, the load connection elements (52, 54, 56) and auxiliary connection elements (58) extending through bushings (344, 348) of the second insulating material body (34), and these bushings (344, 348) being closed in a dust-proof and moisture-proof manner towards the load connection elements (52, 54, 56) and auxiliary connection elements (58).

## Revendications

1. Système électronique de puissance (1) comportant un dispositif de refroidissement (10) ayant un premier corps de base (12), au moins un sous-système (30) et un boîtier (20), dans lequel le dispositif de refroidissement (10) comporte dans son premier corps de base (12) au moins un évidement (160),
l'au moins un sous-système (30) comporte un dispositif de commutation (50) muni d'un circuit électronique de puissance ayant des éléments de raccordement de charge (52, 54, 56) et auxiliaires (58) de polarité différente et muni d'un composant de refroidissement (60) pénétrant dans un évidement associé (160) du dispositif de refroidissement (10), qui forme un creux du premier corps de base (12), lequel composant n'étant respectivement constitué que d'un deuxième corps de base (62) qui est entièrement reçu par complémentarité de forme dans l'évidement (160) du premier corps de base (12) du dispositif de refroidissement (10) et par conséquent vient à se situer à cet endroit, et dans lequel
le boîtier (20) recouvre l'au moins un sous-système (30) vers le dispositif de refroidissement (10).

2. Système électronique de puissance selon la revendication 1, dans lequel
le dispositif de refroidissement (10) est prévu pour des agents de refroidissement gazeux et est à cet effet réalisé sous la forme d'un dispositif de refroidissement à ailettes ayant un premier corps de base (12) en forme de plaque et des premières ailettes de refroidissement (14) partant de celui-ci.

3. Système électronique de puissance selon la revendication 1, dans lequel
le dispositif de refroidissement (10) est prévu pour des agents de refroidissement liquides et comporte de ce fait un premier corps de base (12) en forme de plaque et au moins une cavité se raccordant à celui-ci pour l'agent de refroidissement.

4. Système électronique de puissance selon la revendication 1, dans lequel
l'au moins un évidement (160) comporte une arête de butée périphérique (162) sur laquelle repose une surface de butée (622) du dispositif de refroidissement (60) respectivement associé du sous-système (30).

5. Système électronique de puissance selon la revendication 1 ou 4, dans lequel
un dispositif d'étanchéité (622) est prévu dans la région de bord entre le premier (12) et le deuxième corps de base (62) ou entre l'arête de butée (162) du premier corps de base (12) et la surface de butée (622) du deuxième corps de base (62).

6. Système électronique de puissance selon la revendication 1, dans lequel
un premier corps en matériau isolant (32) entoure au moins un substrat comportant un circuit électronique de puissance (510) d'un dispositif de commutation (50), le recouvre et le renferme de manière hermétiquement étanche par rapport au composant de refroidissement (60) .

7. Système électronique de puissance selon la revendication 11, dans lequel
les éléments de raccordement de charge (52, 54, 56) et auxiliaire (58) passent par des traversées (344, 348) du deuxième corps en matériau isolant (34) et lesdites traversées (344, 348) sont fermées de manière étanche à la poussière et à l'humidité vers les éléments de raccordement de charge (52, 54, 56) et auxiliaires (58) .
